# EUROPÄISCHE PATENTSCHRIFT

(11) **EP 3 508 042 B1**
(45) Veröffentlichungstag und Bekanntmachung des Hinweises auf die Patenterteilung: **27.01.2021**
(21) Anmeldenummer: 17754300.6
(22) Anmeldetag: 02.08.2017
(51) Int. Cl.: H05K 5/00

(54) **LOSLAGERBUCHSE FÜR LEITERPLATTE**
FLOATING BEARING BUSH FOR A PRINTED CIRCUIT BOARD
DOUILLE SUPPORT MOBILE POUR CARTE DE CIRCUIT IMPRIMÉ

(30) Priorität: 05.09.2016 DE 102016216739
(43) Veröffentlichungstag der Anmeldung: 10.07.2019
(73) Patentinhaber: Robert Bosch GmbH, 70442 Stuttgart (DE)
(72) Erfinder: ZWEIGLE, Peter, 71254 Ditzingen (DE); GERHAEUSSER, Martin, 74336 Brackenheim-Stockheim (DE)
(86) Internationale Anmeldenummer: PCT/EP2017/069523
(87) Internationale Veröffentlichungsnummer: WO 2018/041509

(56) Entgegenhaltungen:
- EP-A2- 2 458 951
- DE-A1-102010 030 170
- DE-A1-102014 217 351
- DE-A1-102014 217 889
- US-A1- 2011 085 305

## Beschreibung

### Gebiet der Erfindung

Die Erfindung betrifft eine Loslagerbuchse und ein Steuermodul für ein Fahrzeug.

### Stand der Technik

Die elektronische Schaltung von Getriebesteuermodulen kann auf einer Leiterplatte angeordnet werden. Weiter können die Komponenten der Schaltung durch einen Schutzverguss, beispielsweise in Dam-and-Fill-Technik, vor Motoröl, Getriebeöl, anderen Medien und Kurzschluss durch Späne geschützt werden. Beim Dam-and-Fill-Verfahren wird zunächst ein Damm aus einem hochviskosen Material auf der Leiterplatte um die elektronischen Komponenten erzeugt, und die entstehende Wanne wird mit einer wesentlich weniger viskosen Vergussmasse aufgefüllt, die die elektronischen Komponenten überdeckt.

In der Regel ist die Leiterplatte durch Verschraubung an einem Träger, wie etwa einer Trägerplatte, einem Gehäuse oder einer Montagefläche befestigt (z.B. dem Getriebegehäuse). Die Leiterplatte ist wiederum auf dem Träger so befestigt, dass unterschiedliche Temperaturausdehnungen nicht zu Schäden führen. Wegen der unterschiedlichen Temperaturdehnungskoeffizienten zwischen Träger und Leiterplattenmaterial wird ein Befestigungspunkt als Festlager und weitere Befestigungspunkte als Loslager ausgeführt.

Die Leiterplatte ist normalerweise nicht zur Übertragung der Schraubvorspannkraft geeignet. Daher werden meistens Metallbuchsen zur Aufnahme von Schrauben verwendet, die die Flächenpressung reduzieren. Die Festlagerbuchse kann beispielsweise direkt aufgelötet oder eingepresst werden. Die DE 10 2010 030 170 A1 zeigt ein Steuergerät, bei dem auf einem Schaltungsträger ein Rahmen angeordnet ist, so dass sich eine Wanne bildet, die mit einer Moldmasse aufgefüllt wird.

Die DE 44 05 710 A1 zeigt eine Trägerplatte mit Bauelementen, die mit einem Ring umgeben werden, in den ein Gel gefüllt wird.

Aus der DE 10 2014 217 889 A1 eine Loslagerbuchse zum Lagern einer Leiterplatte bekannt. Die Loslagerbuchse umfasst einen Lagerring mit einer röhrenförmigen Öffnung zur Aufnahme eines Befestigungsbolzens.

Aus der DE 10 2014 217 351 A1 ist ein Steuermodul für ein Fahrzeug bekannt. Das Steuermodul weist eine Leiterplatte auf, die elektronische Komponenten zum Steuern eines Geräts des Fahrzeugs trägt; einen auf die Leiterplatte aufgetragenen Damm, der die elektronischen Komponenten auf der Leiterplatte umgibt; eine Vergussmasse, in die die elektronischen Komponenten eingebettet sind und die innerhalb des Damms auf der Leiterplatte vergossen ist.

### Offenbarung der Erfindung

### Vorteile der Erfindung

Ausführungsformen der vorliegenden Erfindung können in vorteilhafter Weise ermöglichen, eine Leiterplatte mit in eine Vergussmasse eingegossenen elektronischen Komponenten sicher an einem Träger zu fixieren. Weiter kann ein kompaktes und kostengünstiges Steuermodul bereitgestellt werden, das an die Umweltbedingungen im Motorraum eines Fahrzeugs angepasst ist.

Ideen zu Ausführungsformen der vorliegenden Erfindung können unter anderem als auf den nachfolgend beschriebenen Gedanken und Erkenntnissen beruhend angesehen werden.

Ein Aspekt der Erfindung betrifft eine Loslagerbuchse zum Lagern einer Leiterplatte. Eine oder mehrere dieser Loslagerbuchsen können auf die Leiterplatte gelötet werden, um diese an einem Träger zu befestigen.

Gemäß einer Ausführungsform der Erfindung umfasst die Loslagerbuchse einen Lagerring mit einer röhrenförmigen Öffnung zur Aufnahme eines Befestigungsbolzens und einen Lötring, der den Lagerring umgibt und der dazu ausgeführt ist, mit einer Unterkante an eine Leiterplatte gelötet zu werden, wobei die Unterkante des Lötrings von einer durchgehenden Wandung bereitgestellt ist, die dazu ausgeführt ist, eine flüssige Vergussmasse vom Inneren des Lötrings fernzuhalten. Der Lagerring ist innerhalb des Lötrings beweglich aufgehängt bzw. gelagert, so dass der Lagerring zumindest in eine radiale Richtung in Bezug auf den Lötring beweglich ist. Auf diese Weise kann ein Befestigungsbolzen durch den Lagerring, der in einem Träger befestigt ist, sich bezüglich der Leiterplatte bewegen, wenn sich der Träger anders thermisch ausdehnt als die Leiterplatte. Insgesamt kann die Loslagerbuchse ein radiales Spiel zur Befestigung der Leiterplatte bereitstellen und gleichzeitig verhindern, dass Vergussmasse in einen Bereich auslaufen kann, in dem dieses Spiel bereitgestellt wird.

Die Leiterplatte kann aus glasfaserverstärktem Kunststoff hergestellt sein, auf dem Kupferschichten als Leitungsbahnen aufgebracht sind. Auf eine derartige Kupferschicht kann auch die Loslagerbuchse gelötet sein. Die Leiterplatte kann elektronische Komponenten tragen, wie etwa Widerstände, Kondensatoren, Halbleiterschaltelemente und/oder integrierte Schaltkreise, die eine elektronische Schaltung bilden. Die Loslagerbuchse kann zusammen mit den elektronischen Komponenten im SMD-Reflow-Verfahren auf die Leiterplatte aufgelötet werden.

Die Loslagerbuchse und die elektronischen Komponenten können dann mit dem Dam-and-Fill-Verfahren eingegossen werden. D.h., die Leiterplatte kann einen Damm aufweisen, der die elektronischen Komponenten und die Loslagerbuchse umgibt, innerhalb dem eine Vergussmasse vergossen wird, in die die elektronischen Komponenten und die Loslagerbuchse eingebettet werden. Der Lötring verhindert dabei, dass Vergussmasse beim Vergießen in das Innere der Loslagerbuchse gelangen kann. Durch die ringsum bis zur nötigen Höhe geschlossene Ausführung der Loslagerbuchse mit einer durchgehenden Wandung wird das Auslaufen der Schutz-Vergussmasse verhindert, ohne dass weitere Maßnahmen, wie beispielsweise ein weiterer Damm, nötig sind. Damit kann teures Damm-Material eingespart werden, wobei zusätzliche Teile und Arbeitsschritte vermieden werden. Weiter kann eine Platzersparnis erzielt werden.

Der Lötring, der aus Blech hergestellt sein kann, kann aus mehreren Elementen zusammengefügt, wie etwa geschweißt, sein. Das Blech kann zu einem Ring gebogen werden, das die Wandung bereitstellt. Die Wandung kann rund und/oder röhrenförmig sein. In Bereichen des Lötrings, die nicht mit der Vergussmasse in Berührung kommen, können sich Lagerelemente zum Tragen des Lagerrings, Löcher und/oder Führungsstifte für die genaue Positionierung befinden. Auch diese Elemente können aus dem Blech hergestellt sein. Es ist auch möglich, dass die Wandung des Lötrings nicht rund ist, sondern eine beliebige Form besitzt, wie etwa ein Vieleck.

Gemäß einer Ausführungsform der Erfindung ist der Lagerring mit einem radial nach außen abstehenden Rand auf nach innen stehende Lagerelemente des Lötrings aufgesetzt. Der Lagerring kann somit auf den Lagerelementen seitlich rutschen. Die Lagerelemente können Blechzungen sein, die von der Wandung nach innen stehen. Insbesondere können die Lagerelemente Federzungen sein. Durch Federzungen kann eine Dickentoleranz der Leiterplatte ausgeglichen werden und/oder die Leiterplatte immer ausreichend an den Träger angedrückt werden. Gleichzeitig kann die Andruckkraft so klein eingestellt werden, dass ein seitliches Verschieben der Leiterplatte nicht behindert wird.

Gemäß einer Ausführungsform der Erfindung stehen die Lagerelemente radial nach innen. Beispielsweise können Federzungen durch nach innen gebogene Blechstreifen gebildet werden.

Gemäß einer Ausführungsform der Erfindung sind die Lagerelemente in Umfangsrichtung um den Lagerring gekrümmt. Auf diese Weise kann eine höhere Elastizität der Lagerelemente bzw. von Federzungen erreicht werden.

Gemäß einer Ausführungsform der Erfindung ist der Lagerring relativ zu den Lagerelementen beweglich. Beispielsweise kann der Lagerring einen Hinterschnitt bzw. eine radiale Vertiefung aufweisen, in die die Lagerelemente hineinragen. Diese Vertiefung kann gegenüber den Lagerelementen Spiel aufweisen, so dass der Lagerring in radiale Richtung beweglich ist. Mit diesem Hinterschnitt kann auch erreicht werden, dass der Lagerring und der Lötring auch beim Transport aneinander montiert sind und nicht auseinanderfallen können.

Gemäß einer Ausführungsform der Erfindung stellt der Lötring in einem oberen Abschnitt elastische Lagerelemente bzw. Federzungen bereit, mit denen der Lagerring im Lötring gelagert ist, wobei die elastischen Lagerelemente von nach innen gebogenen Abschnitten, beispielsweise Blechstreifen, des Lötrings bereitgestellt sind.

Gemäß einer Ausführungsform der Erfindung ist der Lagerring in die elastischen Lagerelemente eingeklemmt. Es kann auch sein, dass der Lagerring bezüglich der Lagerelemente nicht beweglich ist, sondern dass eine Bewegung des Lagerrings nur durch elastische Verformung der Lagerelemente erfolgen kann. Gemäß einer Ausführungsform der Erfindung ist ein oberer Abschnitt des Lötrings bogenförmig um mehr als 90° nach innen gebogen. Weiter können Lagerelemente für den Lagerring radial innen an dem oberen Abschnitt angebracht sein. Der Lötring kann aus einem Blech hergestellt sein, das in einem unteren Abschnitt die Wandung bereitstellt und das zum Bilden des oberen Abschnitts nach innen gebogen wurde. Aus diesem Blech können auch die Lagerelemente ausgestanzt worden sein, die an den oberen Abschnitt anschließen und wiederum so gebogen wurden, dass sie nach radial innen weisen.

Gemäß einer Ausführungsform der Erfindung weist der Lötring einen Führungsstift auf, der von einem oberen Abschnitt des Lötrings über die Unterkante des Lötrings hinausragt. Der Führungsstift kann in ein Führungsloch in der Leiterplatte gesteckt werden, um den Lötring bzw. die Loslagerbuchse vor dem Löten zu fixieren. Der Führungsstift kann auch aus dem Blech ausgestanzt sein, aus dem die Wandung und die Lagerelemente des Lötrings gebildet sind.

Es ist aber auch möglich, dass die Positionierung der Loslagerbuchse lediglich durch die Bestückung in die Lotpaste und den Lötvorgang geschieht und keine Führungselemente vorhanden sind.

Ein weiterer Aspekt der Erfindung betrifft ein Steuermodul für ein Gerät eines Fahrzeugs. Das Steuermodul kann eine Leiterplatte, so wie obenstehend und untenstehend beschrieben, mit elektronischen Komponenten zum Steuern des Geräts umfassen, das beispielsweise ein Getriebe bzw. ein Automatikgetriebe sein kann. Neben den elektronischen Komponenten, die eine Steuerschaltung bilden können, kann das Steuermodul elektrische Anschlüsse, Sensoren und/oder Aktuatoren umfassen bzw. diese kontaktieren. Das Steuermodul kann über die Leiterplatte an dem Gerät, beispielsweise einem Getriebe, angebracht sein und auch mit diesem elektrisch verbunden sein. Das Fahrzeug kann ein Pkw, Lkw oder Bus sein.

Gemäß einer Ausführungsform der Erfindung umfasst das Steuermodul eine Leiterplatte, die elektronische Komponenten zum Steuern eines Geräts des Fahrzeugs trägt; einen auf die Leiterplatte aufgetragenen Damm, der die elektronischen Komponenten auf der Leiterplatte umgibt; eine Vergussmasse, in die die elektronischen Komponenten eingebettet sind und die innerhalb des Damms auf der Leiterplatte vergossen ist. Weiter umfasst das Steuermodul eine innerhalb des Damms auf die Leiterplatte gelötete Loslagerbuchse mit einem Lagerring mit einer röhrenförmigen Öffnung zur Aufnahme eines Befestigungsbolzens und einem Lötring, der den Lagerring umgibt und der mit einer Unterkante an die Leiterplatte gelötet ist, wobei der Lötring in die Vergussmasse eingegossen ist und wobei der Lagerring innerhalb des Lötrings beweglich aufgehängt ist, so dass der Lagerring zumindest in eine radiale Richtung in Bezug auf den Lötring beweglich ist.

Der Lötring kann eine Wandung aufweisen, die beim Vergießen davor schützt, dass das Innere des Lötrings, d.h. der Bereich, in dem der Lagerring aufgenommen ist, sich mit Vergussmasse füllt. Somit kann der Lötring genauso wie die elektronischen Komponenten auf die Leiterplatte bestückt und in die Vergussmasse eingegossen werden. Ein oberer Abschnitt des Lötrings kann nach dem Vergießen aus der Vergussmasse herausragen.

Der Befestigungsbolzen kann eine Schraube sein, mit der das Steuermodul bzw. die Leiterplatte an einem Träger, beispielsweise einer Trägerplatte oder einem Gehäuse, verschraubt ist. Der Lagerring kann durch ein Loch in der Leiterplatte durch die Leiterplatte ragen, so dass der Befestigungsbolzen durch die Leiterplatte geführt werden kann.

Gemäß einer Ausführungsform der Erfindung umfasst das Steuermodul weiter eine innerhalb des Damms auf die Leiterplatte gelötete Festlagerbuchse, die eine Öffnung zur Aufnahme eines Befestigungsbolzens bereitstellt, die in ein weiteres Loch in der Leiterplatte mündet. Das Steuermodul bzw. die Leiterplatte wird in der Regel mit einer (einzigen) Festlagerbuchse und mehreren Loslagerbuchsen an dem Träger befestigt werden.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1 zeigt schematisch einen Querschnitt durch ein Steuermodul gemäß einer Ausführungsform der Erfindung.
Fig. 2 zeigt schematisch einen Teilquerschnitt durch ein Steuermodul gemäß einer weiteren Ausführungsform der Erfindung.
Fig. 3 zeigt eine perspektivische Ansicht einer Loslagerbuchse gemäß einer Ausführungsform der Erfindung.
Fig. 4 zeigt eine perspektivische Ansicht einer Loslagerbuchse gemäß einer weiteren Ausführungsform der Erfindung.
Fig. 5 zeigt eine perspektivische Ansicht einer Loslagerbuchse gemäß einer weiteren Ausführungsform der Erfindung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

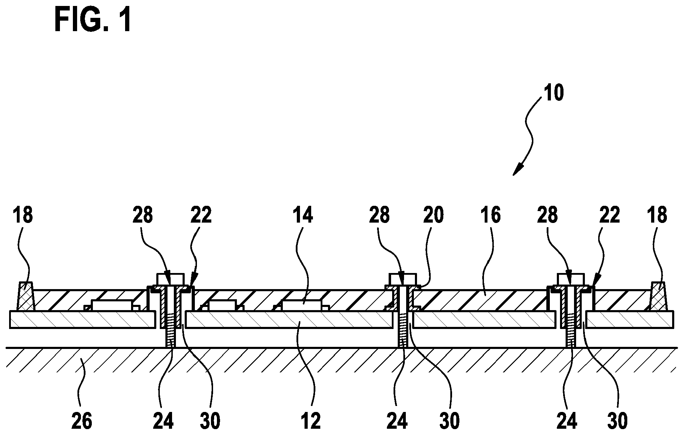

Fig. 1 zeigt ein Getriebesteuermodul 10, das eine Leiterplatte 12 umfasst, auf der elektronische Komponenten 14 angebracht sind, die in eine Vergussmasse 16 eingebettet sind. Die elektronischen Komponenten 14 sind von einem Damm 18 umgeben, der beispielsweise abschnittsweise am Rand der Leiterplatte 12 verlaufen kann. Die elektronischen Komponenten 14 können eine Schaltung bilden, mit der ein Gerät in einem Fahrzeug, wie etwa ein Automatikgetriebe, gesteuert werden kann.

Zusammen mit der Leiterplatte 12 bildet der Damm 18 eine Wanne, in der sich die elektronischen Komponenten 14 befinden und in der sie in die erste Vergussmasse 16 eingegossen worden sind. Beispielsweise kann der Damm 18 als Kunststoffmaterial mit hoher Viskosität auf die Leiterplatte 12 aufgetragen werden und dann die Vergussmasse 16 als Kunststoffmaterial niedriger Viskosität innerhalb des Damms 18 eingegossen werden. Anschließend können beide Kunststoffmaterialien ausgehärtet werden.

Auf der Bestückungsseite der Leiterplatte 12, auf der sich die elektronischen Komponenten befinden, sind weiter eine Festlagerbuchse 20 und mehrere Loslagerbuchsen 22 angebracht, mit denen die Leiterplatte 12 mittels Befestigungsbolzen 24 (wie etwa Schrauben) an einem Träger 26, der beispielsweise das Gehäuse eines Automatikgetriebes sein kann, befestigt ist.

Die Festlagerbuchse 20 und die Loslagerbuchsen 22 sind auf die Leiterplatte 12 gelötet und in die Vergussmasse 16 eingegossen, wobei ein oberer Abschnitt aus der Vergussmasse 16 herausragt. Sowohl die Festlagerbuchse 20 als auch die Loslagerbuchsen 22 weisen jeweils eine Öffnung 28 auf, die über einem Loch 30 in der Leiterplatte 12 angeordnet ist und durch die der jeweilige Befestigungsbolzen 24 gesteckt ist.

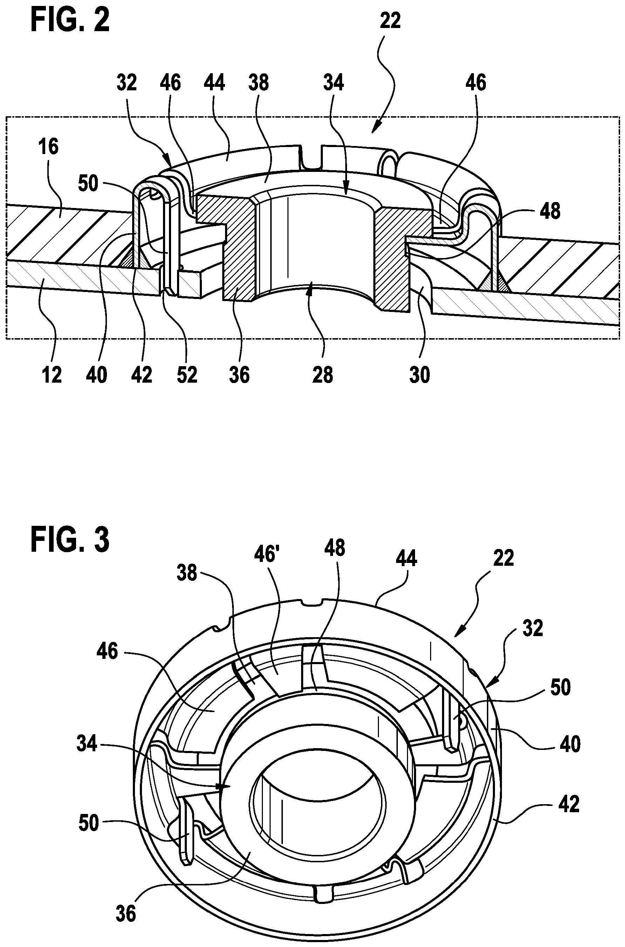

Die Fig. 2 zeigt eine Loslagerbuchse 22 detaillierter. Die Loslagerbuchse 22 weist einen Lötring 32 auf, in dem ein Lagerring 34 gelagert ist.

Der Lagerring 34 ist im Wesentlichen zylinderförmig und stellt die Öffnung 28 bereit, die zur Aufnahme des Befestigungsbolzens 24 dient. Ein unterer Teil des zylinderförmigen Körpers 36 des Lagerrings 34 ragt durch das Loch 30 in der Leiterplatte 12, das einen größeren Durchmesser als der zylinderförmige Körper 36 aufweist. An einem oberen Ende weist der Lagerring 34 einen radial nach außen abstehenden Rand 38 auf, der einen größeren Durchmesser als das Loch 30 in der Leiterplatte aufweist und mit dem der Lagerring 34 auf dem Lötring abgesetzt ist.

Der Lötring 32 weist eine äußere Wandung 40 auf, die mit einer Unterkante 42 auf die Leiterplatte 12 gelötet ist. Diese Wandung 40 sowie der Lötring 32 können einstückig oder mehrstückig gefertigt sein. Weiter kann die Wandung 40 rund sein oder vieleckig. Beispielsweise kann der Lötring 32 aus einem Blech hergestellt sein, das zu dem Lötring 32 gebogen und dann zum Schließen der Wandung verschweißt wird.

Die Wandung 40 ist durchgehend und weist bis zu einem oberen Abschnitt 44 des Lötrings 32 keine Löcher oder Aussparungen auf, so dass beim Vergießen keine Vergussmasse in den Innenraum des Lötrings 32 gelangen kann.

Der obere Abschnitt 44 des Lötrings 32 ist U-förmig nach innen umgebogen. Anschließend weist er mehrere Lagerelemente 46 in der Form von Federzungen 46 auf, die radial nach innen verlaufen und auf denen der Lagerring 34 abgesetzt ist. Ab dem oberen Abschnitt 44 weist der Lötring 32 radiale Einschnitte auf, die die Lagerelemente 46 voneinander abtrennen.

Direkt unterhalb des Rands 38 weist der Lagerring 34 einen Hinterschnitt 48 bzw. eine ringförmige Vertiefung 48 auf, in die die Lagerelemente 46 mit ihren Spitzen gesteckt sind. Der Lagerring 34 und die Lagerelemente 46 können im Hinterschnitt 48 in Anschlag stehen oder es kann ein Abstand vorhanden sein, der eine Radialbewegung des Lagerrings 34 relativ zu den Lagerelementen 46 gestattet. Ohne diesen Abstand kann eine Bewegung der Lagerbuchse 34 in radiale als auch in axiale Richtung relativ zur Leiterplatte 12 durch die elastischen Lagerelemente 46 gewährleistet werden.

In der Fig. 2 ist weiter ein Führungsstift 50 zu erkennen, der vom oberen Abschnitt 44 des Lötrings 32 im Wesentlichen parallel zu der Wandung 40 nach unten führt und der in ein weiteres Loch 52 in der Leiterplatte 12 eingesteckt ist. Der Führungsstift 50 dient zum Fixieren und Positionieren der Loslagerbuchse 22 an der Leiterplatte 12, bevor die Loslagerbuchse 22 mit dieser verlötet wird.

Die Fig. 3 zeigt die Loslagerbuchse 22 aus der Fig. 2 von unten. Es ist zu erkennen, dass die Loslagerbuchse 22 zwei gegenüberliegende Führungsstifte 50 aufweist. Weiter ist zu erkennen, dass der Lagerring 34 auf ersten Lagerelementen 46 abgesetzt ist, zwischen deren Spitze und dem zylinderförmigen Körper 36 ein Abstand vorhanden ist, und dass der Lagerring weitere Lagerelemente 46' aufweist, deren Spitzen in dem Hinterschnitt 48 stecken. Beide Typen Lagerelemente 46' verlaufen radial nach innen und/oder verjüngen sich nach radial innen. Die Lagerelemente 46 sind in Umfangsrichtung breiter als die Lagerelemente 46'.

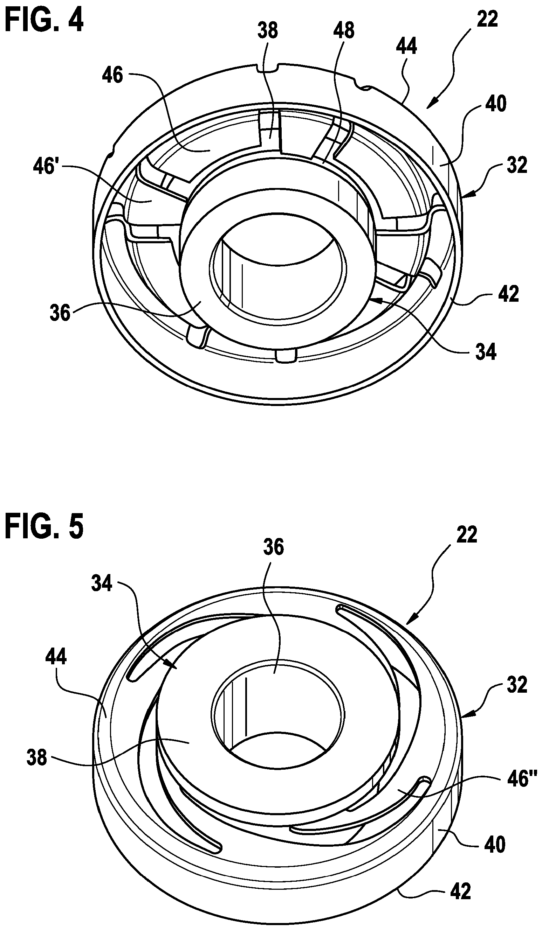

Die Fig. 4 zeigt eine Loslagerbuchse 22 analog der Fig. 3, die allerdings keine Führungsstifte 50 umfasst. Wie bei der Fig. 4 sind die Lagerelemente 46 und 46' in Umfangsrichtung abwechselnd angeordnet.

Die Fig. 5 zeigt eine weitere Ausführungsform einer Loslagerbuchse 22, bei der der obere Abschnitt lediglich um 90° gekrümmt ist und die davon nach innen abstehenden Lagerelemente bzw. Federzungen 46" in Umfangsrichtung um den Lagerring 34 gekrümmt sind. Dies kann die Elastizität der Lagerelemente 46" erhöhen. Auch die Lagerelemente 46" können sich zum Lagerring 34 hin verjüngen.

Abschließend ist darauf hinzuweisen, dass Begriffe wie "aufweisend", "umfassend" etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Loslagerbuchse (22) zum Lagern einer Leiterplatte (12), die Loslagerbuchse (22) umfassend:
einen Lagerring (34) mit einer röhrenförmigen Öffnung (28) zur Aufnahme eines Befestigungsbolzens (24);
**gekennzeichnet durch**
einen Lötring (32), der den Lagerring (34) umgibt und der dazu ausgeführt ist, mit einer Unterkante (42) an eine Leiterplatte (12) gelötet zu werden;
wobei die Unterkante (42) des Lötrings (32) von einer durchgehenden Wandung (40) bereitgestellt ist, die dazu ausgeführt ist, eine flüssige Vergussmasse (16) vom Inneren des Lötrings (32) fernzuhalten;
wobei der Lagerring (34) innerhalb des Lötrings (32) beweglich aufgehängt ist, so dass der Lagerring (34) zumindest in eine radiale Richtung in Bezug auf den Lötring (32) beweglich ist.

2. Loslagerbuchse (22) nach Anspruch 1,
wobei der Lagerring (34) mit einem radial nach außen abstehenden Rand (38) auf nach innen stehende Lagerelemente (46) des Lötrings (32) aufgesetzt ist.

3. Loslagerbuchse (22) nach Anspruch 1 oder 2,
wobei die Lagerelemente (46) radial nach innen stehen; oder
wobei die Lagerelemente (46") in Umfangsrichtung um den Lagerring (34) gekrümmt sind.

4. Loslagerbuchse (22) nach einem der vorhergehenden Ansprüche,
wobei der Lagerring (34) relativ zu den Lagerelementen (46) beweglich ist.

5. Loslagerbuchse (22) nach einem der vorhergehenden Ansprüche,
wobei der Lötring (32) in einem oberen Abschnitt (44) elastische Lagerelemente (46') bereitstellt, mit denen der Lagerring (34) im Lötring (32) gelagert ist; und/oder
wobei die elastischen Lagerelemente (46') von nach innen gebogenen Abschnitten des Lötrings (32) bereitgestellt sind.

6. Loslagerbuchse (22) nach Anspruch 5,
wobei der Lagerring (34) in die elastischen Lagerelemente (46') eingeklemmt ist.

7. Loslagerbuchse (22) nach einem der vorhergehenden Ansprüche, wobei ein oberer Abschnitt (44) des Lötrings (32) bogenförmig um mehr als 90° nach innen gebogen ist und Lagerelemente (46) für den Lagerring (32) radial innen an dem oberen Abschnitt (44) angebracht sind.

8. Loslagerbuchse (22) nach einem der vorhergehenden Ansprüche, wobei der Lötring (32) einen Führungsstift (50) aufweist, der von einem oberen Abschnitt (44) des Lötrings (32) über die Unterkante (42) des Lötrings (32) hinausragt.

9. Steuermodul (10) für ein Fahrzeug, das Steuermodul (10) umfassend:
eine Leiterplatte (12), die elektronische Komponenten (14) zum Steuern eines Geräts des Fahrzeugs trägt;
einen auf die Leiterplatte (12) aufgetragenen Damm (18), der die elektronischen Komponenten (14) auf der Leiterplatte umgibt;
eine Vergussmasse (16), in die die elektronischen Komponenten (14) eingebettet sind und die innerhalb des Damms (18) auf der Leiterplatte vergossen ist;
**gekennzeichnet durch**
eine innerhalb des Damms (18) auf die Leiterplatte (12) gelötete Loslagerbuchse (22) mit einem Lagerring (34) mit einer röhrenförmigen Öffnung (28) zur Aufnahme eines Befestigungsbolzens (24) und einem Lötring (32), der den Lagerring (34) umgibt und der mit einer Unterkante (42) an die Leiterplatte (12) gelötet ist;
wobei der Lötring (32) in die Vergussmasse (16) eingegossen ist; und
wobei der Lagerring (34) innerhalb des Lötrings (32) am Lötring (32) beweglich aufgehängt ist, so dass der Lagerring (34) zumindest in eine radiale Richtung in Bezug auf den Lötring (32) beweglich ist.

10. Steuermodul (10) nach Anspruch 9, weiter umfassend:
eine innerhalb des Damms (18) auf die Leiterplatte (12) gelötete Festlagerbuchse (20), die eine Öffnung zur Aufnahme eines Befestigungsbolzens (24) bereitstellt, die in ein weiteres Loch in der Leiterplatte mündet.

## Claims

1. Floating bearing bush (22) for mounting a printed circuit board (12), the floating bearing bush (22) comprising:
a bearing ring (34) having a tubular opening (28) for receiving a fastening bolt (24);
**characterized by**
a soldering ring (32) which surrounds the bearing ring (34) and which by way of a lower edge (42) is embodied so as to be soldered to a printed circuit board (12);
wherein the lower edge (42) of the soldering ring (32) is provided by a continuous wall (40) which is embodied so as to keep a liquid casting compound (16) away from the interior of the soldering ring (32);
wherein the bearing ring (34) within the soldering ring (32) is suspended so as to be movable such that the bearing ring (34) is movable at least in a radial direction in relation to the soldering ring (32).

2. Floating bearing bush (22) according to Claim 1, wherein the bearing ring (34) by way of a periphery (38) that projects radially outward is placed on bearing elements (46) of the soldering ring (32) that project inward.

3. Floating bearing bush (22) according to Claim 1 or 2, wherein the bearing elements (46) project radially inward; or wherein the bearing elements (46") in the' circumferential direction are curved around the bearing ring (34).

4. Floating bearing bush (22) according to one of the preceding claims, wherein the bearing ring (34) is movable relative to the bearing elements (46).

5. Floating bearing bush (22) according to one of the preceding claims, wherein the soldering ring (32) in an upper portion (44) provides elastic bearing elements (46') by way of which the bearing ring (34) is mounted in the soldering ring (32); and/or wherein the elastic bearing elements (46') are provided by portions of the soldering ring (32) that are bent inward.

6. Floating bearing bush (22) according to Claim 5, wherein the bearing ring (34) is jammed into the elastic bearing elements (46').

7. Floating bearing bush (22) according to one of the preceding claims, wherein an upper portion (44) of the soldering ring (32) is bent in an arcuate inward manner by more than 90°, and bearing elements (46) for the bearing ring (32) are attached to the upper portion (44) in a radially inward manner.

8. Floating bearing bush (22) according to one of the preceding claims, wherein the soldering ring (32) has a guide pin (50) which from an upper portion (44) of the soldering ring (32) protrudes beyond the lower edge (42) of the soldering ring (32).

9. Control module (10) for a vehicle, the control module (10) comprising:
a printed circuit board (12) which supports electronic components (14) for controlling an apparatus of the vehicle;
a dam (18) which is applied to the printed circuit board (12) and which surrounds the electronic components (14) on the printed circuit board;
a casting compound (16) in which the electronic components (14) are embedded and which is cast within the dam (18) on the printed circuit board;
**characterized by**
a floating bearing bush (22) which within the dam (18) is soldered to the printed circuit board (12) and which has a bearing ring (34) having a tubular opening (28) for receiving a fastening bolt (24), and a soldering ring (32) which surrounds the bearing ring (34) and which by way of a lower edge (42) is soldered to the printed circuit board (12);
wherein the soldering ring (32) is cast in the casting compound (16); and
wherein the bearing ring (34) within the soldering ring (32) is suspended so as to be movable on the soldering ring (32) such that the bearing ring (34) is movable at least in a radial direction in relation to the soldering ring (32).

10. Control module (10) according to Claim 9, furthermore comprising:
a fixed bearing bush (20) which within the dam (18) is soldered to the printed circuit board (12) and which provides an opening for receiving a fastening bolt (24), which opening opens into a further bore in the printed circuit board.

## Revendications

1. Coussinet flottant (22) destiné à supporter une carte de circuit imprimé (12), le coussinet flottant (22) comprenant :
une bague de palier (34) pourvue d'une ouverture tubulaire (28) destinée à recevoir un boulon de fixation (24) ;
**caractérisé par**
une bague de soudage (32) qui entoure la bague de palier (34) et qui est conçue pour être soudée, par un bord inférieur (42), à une carte de circuit imprimé (12) ;
le bord inférieur (42) de la bague de soudage (32) étant fourni par une paroi continue (40) qui est conçue pour maintenir un composé d'enrobage liquide (16) éloigné de l'intérieur de la bague de soudage (32) ;
la bague de palier (34) étant suspendue de manière mobile à l'intérieur de la bague de soudage (32) de sorte que la bague de palier (34) soit mobile au moins dans une direction radiale par rapport à la bague de soudage (32).

2. Coussinet flottant (22) selon la revendication 1, la bague de palier (34) étant placée, par un bord (38) faisant saillie radialement vers l'extérieur, sur des éléments de palier (46) faisant saillie vers l'intérieur de la bague de soudage (32).

3. Coussinet flottant (22) selon la revendication 1 ou 2,
les éléments de palier (46) faisant saillie radialement vers l'intérieur ; ou
les éléments de palier (46") étant incurvés dans la direction circonférentielle autour de la bague de palier (34).

4. Coussinet flottant (22) selon l'une des revendications précédentes,
la bague de palier (34) étant mobile par rapport aux éléments de palier (46).

5. Coussinet flottant (22) selon l'une des revendications précédentes,
la bague de soudage (32) fournissant, dans une portion supérieure (44), des éléments de palier élastiques (46') avec lesquels la bague de palier (34) est montée dans la bague de soudage (32) ; et/ou
les éléments de palier élastiques (46') étant fournis par des portions pliées vers l'intérieur de la bague de soudage (32).

6. Coussinet flottant (22) selon la revendication 5, la bague de palier (34) étant serrée dans les éléments de palier élastiques (46').

7. Coussinet flottant (22) selon l'une des revendications précédentes,
une portion supérieure (44) de la bague de soudage (32) étant incurvée vers l'intérieur sur plus de 90° et des éléments de palier (46) destinés à la bague de palier (32) étant fixés radialement vers l'intérieur à la portion supérieure (44).

8. Coussinet flottant (22) selon l'une des revendications précédentes,
la bague de soudage (32) comportant une broche de guidage (50) qui fait saillie d'une portion supérieure (44) de la bague de soudage (32) depuis le bord inférieur (42) de la bague de soudage (32).

9. Module de commande (10) destiné à un véhicule, le module de commande (10) comprenant :
une carte de circuit imprimé (12) qui porte des composants électroniques (14) destinés à commander un appareil du véhicule ;
une barrière (18) qui est appliquée sur la carte de circuit imprimé (12) et qui entoure les composants électroniques (14) sur la carte de circuit imprimé ;
un composé d'enrobage (16) dans lequel les composants électroniques (14) sont incorporés et qui est coulé sur la carte de circuit imprimé à l'intérieur de la barrière (18) ;
**caractérisé par**
un coussinet flottant (22) qui est soudé à la carte de circuit imprimé (12) à l'intérieur de la barrière (18) et qui comporte une bague de palier (34) pourvue d'une ouverture tubulaire (28) destinée à recevoir un boulon de fixation (24) et une bague de soudage (32) qui entoure la bague de palier (34) et qui est soudé, par un bord inférieur (42), à la carte de circuit imprimé (12) ;
la bague de soudage (32) étant enrobée dans le composé d'enrobage (16) ; et
la bague de palier (34) à l'intérieur de la bague de soudage (32) étant suspendue de manière mobile à la bague de soudage (32) de sorte que la bague de palier (34) soit mobile au moins dans une direction radiale par rapport à la bague de soudage (32).

10. Module de commande (10) selon la revendication 9, comprenant en outre :
un coussinet fixe (20) soudé sur la carte de circuit imprimé (12) à l'intérieur de la barrière (18) et fournissant une ouverture destinée à recevoir un boulon de fixation (24) qui débouche dans un autre trou ménagé dans le circuit imprimé.
